Europäisches Patentamt

(19) European Patent Office

Office européen des brevets

(11) EP 0 923 139 A2

(12) EUROPEAN PATENT APPLICATION

(43) Date of publication:
16.06.1999 Bulletin 1999/24

(51) Int. Cl.$^6$: H01L 29/788, G11C 11/40

(21) Application number: 98403043.7

(22) Date of filing: 04.12.1998

(84) Designated Contracting States:
AT BE CH CY DE DK ES FI FR GB GR IE IT LI LU
MC NL PT SE
Designated Extension States:
AL LT LV MK RO SI

(30) Priority: 05.12.1997 JP 33619297
15.04.1998 JP 10481198

(71) Applicant: SONY CORPORATION
Tokyo (JP)

(72) Inventors:
• Moriya, Hiroyuki,
c/o Sony Corporation
Tokyo (JP)

• Komatsu, Yasutoshi,
c/o Sony Corporation
Tokyo (JP)
• Hayashi, Yutaka,
c/o Sony Corporation
Tokyo (JP)

(74) Representative:
Thévenet, Jean-Bruno et al
Cabinet Beau de Loménie
158, rue de l'Université
75340 Paris Cédex 07 (FR)

(54) **Nonvolatile semiconductor memory device and method of application of write voltage of the same**

(57)    A nonvolatile semiconductor memory device capable of applying a write inhibit voltage larger than minimum value out of individual breakdown voltages between a channel (14a) and a channel forming region (14), between a drain region (12) and the channel forming region (14), and between a source region (13) and the channel forming region (14) is provided, by forming depletion layers (19a) extending from a drain region (12) and a source region (13) so as to extend in a parallel direction to the surface of the channel forming region (14) and by shortening the channel length being superimposed in the channel forming region (14) when a reverse bias is applied between the drain region (12) and the channel forming region (14) and between the source region (13) and the channel forming region (14).

FIG.1

**Description**

BACKGROUND OF THE INVENTION

1. Field of the Invention

The present invention relates to a nonvolatile semiconductor memory device for discriminating information according to a stored amount of charges in a charge storing means comprising a floating gate embedded in so-called a gate insulating film, or conductor grains, semiconductor grains, carrier trapping sites, and so on distributed discretely in the gate insulating film and a method of application of a write voltage of the same.

2. Description of the Related Art

As a nonvolatile semiconductor memory device for discriminating information according to the stored amount of a charge in a charge storing means comprising a floating gate embedded in a gate insulating film, or conductor grains, semiconductor grains, carrier trapping sites, and so on distributed discretely in the gate insulating film, there are a flash EEPROM (flash memory) under vigorous development in recent years and so on.

In flash memories, the mainstream has been the CHE/FN tunnel injection method like a so-called NOR type where channel hot electrons (CHE) are injected into the floating gate at the time of writing and electrons are pulled out from the floating gate by Fowler-Nordheim (FN) tunneling at the time of erasure.

The write operation in this CHE/FN tunnel injection method is carried out in units of one to several bytes.

However, the CHE/FN tunnel injection method has the problems that a high voltage generation circuit becomes large since the channel current required for the write operation is large and so on.

For this reason, a flash memory not based on the CHE/FN tunnel injection method, but based on the FN tunnel method at both of the write and erase operations has been proposed.

The write operation of the flash memory of this FN/FN tunnel injection method is usually carried out in parallel for all bits, that is, in units of one word line, in order to make the write time per byte almost the same as that of a flash memory of CHE writing and so on.

Then, as a flash memory for performing a write operation of data by FN tunneling, there are a so-called NAND type, AND type, DINOR type, etc.

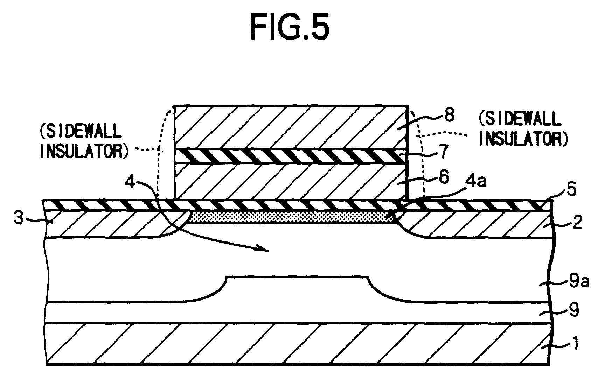

Figure 5 is a view of the sectional structure of a nonvolatile semiconductor memory device having a floating gate embedded in the gate insulating film as a charge storing means (charge storing layer).

As shown in Fig. 5, this nonvolatile semiconductor memory device is formed with a drain region 2 and a source region 3 in a well 9 formed in a surface region of a semiconductor substrate 1 at predetermined intervals.

Further, a floating gate 6 is formed as a charge storing layer electrically insulated via an insulating film 5 above a channel forming region 4 comprised of the semiconductor region sandwiched between the drain region 2 and the source region 3 and having a surface region in which a channel is formed so as to be sandwiched between the drain region 2 and the source region 3 and is formed with a control gate 8 for controlling the voltage of the floating gate 6 via an inter-layer insulating film 7.

Note that, here, the insulating film 5 and the inter-layer insulating film 7 are referred to overall as the gate insulating film and it is generally expressed that the floating gate comprising the charge storing means is embedded in the gate insulating film.

In this Figure 5 sidewall insulators usually furnished on the sidewall of the floating gate 6 is not shown and herein after the similar simplification in the drawings and explanation will be adopted in this invention.

In this way, one of procedures of the operation at the time of the write operation by the FN tunnel method in a nonvolatile semiconductor memory device having a floating gate 6 and a control gate 8 and discriminating the information of cells by the stored amount of a charge in the floating gate is as follows.

Namely, a write operation is carried out by injecting electrons from the channel 4a into the floating gate by applying a positive high voltage to the control gate 8 by setting the well 9 in the surface of the semiconductor substrate 1 and the channel forming region 4 to 0V and setting the voltage of the drain region 2 and the source region 3 of the memory cell to 0V.

In a memory cell connected to the same word line as the control gate 8 of the writing cell, but which is not selected and does not intend to inject electrons from the channel 4a into the floating gate 6 and is called non-selected memory cell, it is necessary to set the drain and source voltages of the memory cell at positive voltages.

This is aimed at weakening an electric field between the channel and the floating gate by reducing the voltage difference between the channel and the floating gate and as a result a reduction of the amount of electrons injected from the channel into the floating gate.

Note that, as shown in Fig. 5, a high voltage is applied to the control gate 8 at the time of the write operation, so the channel 4a is formed in the channel forming region 4.

Further, in a non-selected memory cell, an inhibit voltage $V_M$ is applied to the drain region 2 and the source region 3, while depletion layers 9a are formed in the well 9 and the channel forming region 4. The depletion layer 9a extending into the channel forming region comprises depletion layers extending from junction portions between the source region and the channel forming region and between the drain region and the channel forming region, and the depletion layer extending from the channel. The former is formed only by the voltage difference between the source region and the channel forming region and between the drain region and the channel forming region for example even when a flat band voltage is applied to the gate.

When the channel length is longer than a sum of widths of depletion layers extending from junction portions between the source region and the channel forming region and between drain region and the channel forming region, an electric field is formed in a vertical direction to the surface in the depletion layer between the channel 4a and the channel forming region 4. For this reason, the breakdown voltage near that of step like junction between the channel and the channel forming region limits the inhibit voltage.

In the above write operation, the inhibit voltage $V_M$ applied to the drain region 2 and the source region 3 of a cell for which the write operation must be inhibited usually becomes 6V to 10V in many cases, but here there is a problem with the electrical potential (hereinafter, will be simply referred to as "potential") at the channel of the non-selected memory cell and a breakdown voltage between the channel and the channel forming region.

This disadvantage will be considered below.

Where the gate length of a memory cell is reduced along with the miniaturization of elements in recent years, it is necessary to make the concentration of impurities of the channel forming region 4 larger from the viewpoint of prevention of occurrence of so-called punch through along with the reduction of the gate length, but along with this, there is a tendency toward reduction of the breakdown voltage between the channel and the channel forming region formed at the time of the write operation.

Accordingly, along with the reduction of the gate length, the margin of the inhibit voltage applied to the source region and the drain region decreases since the breakdown voltage between the channel and the channel forming region is lowered.

The above fact will be described in further detail with reference to Fig. 5.

As explained above, a high voltage is applied to the control gate at the time of a write operation, therefore the channel 4a is formed in the surface of the channel forming region 4.

Further, the inhibit voltage is applied to the drain region 2 and the source region 3, the potential of the channel rises, and depletion layers 9a are formed. When the channel length is longer than the sum of widths of the depletion layers extending from junction portions between the source region and the channel forming region and between the drain region and the channel forming region, a depletion layer having a breakdown voltage near that of the step junction is formed between the channel and the channel forming region.

Accordingly, for the breakdown voltage, the breakdown voltages between the drain region 2 and the channel forming region and between the source region 3 and the channel forming region, and the breakdown voltage between the channel and the channel forming region must be considered.

The impurity concentration of the channel forming region must be made larger so as to suppress the punch through along with the reduction of the channel length of the memory cell, therefore the breakdown voltage between the channel and the channel forming region formed at the time of the write operation is reduced.

To prevent punch-through between the drain and source, the impurity concentration of the channel forming region is designed to be larger than that of the other part of the well, and this result that breakdown voltages of the source and drain regions with reference to the channel forming region is lower than those with reference to the other part of the well.

On the other hand, by lowering the impurity concentration of the drain region 2 and the source region 3, especially at the part facing each other, so called "source drain extension", the breakdown voltages of the drain region and the source region with reference to the channel forming region and the well can be improved.

Accordingly, when the channel length of the memory cell becomes short and the impurity concentration of the channel forming region is made larger, the breakdown voltage is determined by the breakdown voltage between the channel and the channel forming region rather than junction breakdown voltages of the drain region 2 and the source region 3 with reference to the channel forming region.

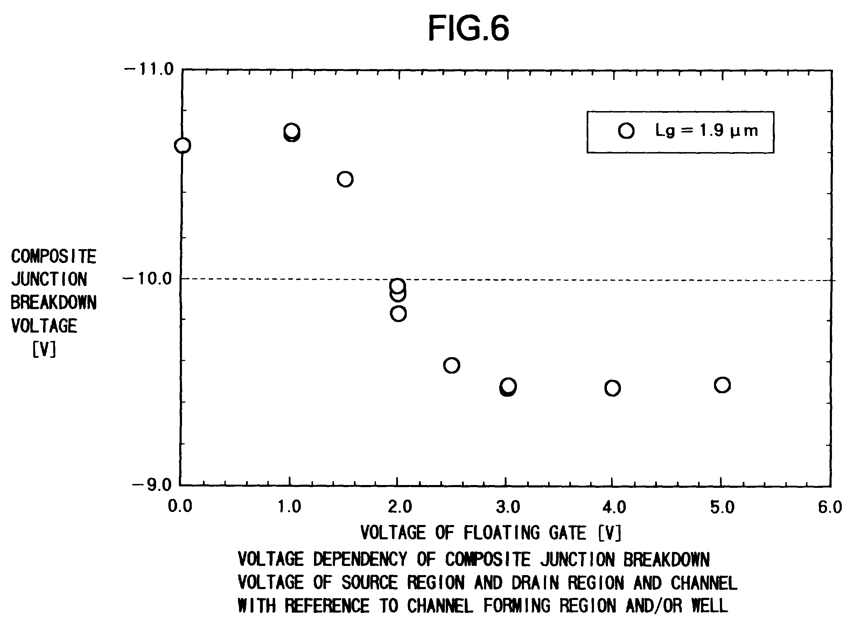

Figure 6 is a graph showing of an example of the relationship between the voltage of the floating gate (FG) and the composite breakdown voltage of the drain and source regions and the channel with reference to the channel forming region and the well (composite junction breakdown voltage). The channel length Lg of the specimen used here is 1.9 μm.

In Fig. 6, the abscissa represents the voltage applied between the floating gate and the source, drain regions, while the ordinate represents a composite junction breakdown voltage of individual breakdown voltages of the source region and of the drain region and of the channel with reference to the channel forming region and/or well.

In this example, the channel is formed when the voltage of the floating gate is about 2V or more.

As understood from Fig. 6, until the channel is formed, the composite junction breakdown voltage is the breakdown voltages of the drain region and of the source region with reference to the channel forming region and/or the well, but when the channel is formed (electrically induced) at the voltage of the floating gate of about 2V or more, the breakdown voltage between the formed channel and the channel forming region dominates the composite junction breakdown voltage and the value of that is lowered, therefore the margin with respect to the inhibit voltage applied to the channel becomes smaller.

SUMMARY OF THE INVENTION

An object of the present invention is to provide a nonvolatile semiconductor memory device capable of applying an inhibit voltage of not less than minimum voltage out of individual voltages of the channel and, the drain region, and the source region with respect to the channel forming region and/or the well, and a method of application of the write voltage of the same.

To attain the above object, according to a first aspect of the present invention, there is provided a nonvolatile semiconductor memory device comprising a channel forming region made of a semiconductor and electrically forming a channel in its surface; a source region and a drain region provided apart from each other in contact with the channel forming region; a gate insulating film formed on the channel forming region; a charge storing means embedded in the gate insulating film; and a control gate arranged above the charge storing means via the gate insulating film, wherein depletion layers extending from a junction portion between the source region and the channel forming region and from a junction portion between the drain region and the channel forming region are formed so as to be superimposed on each other in the channel forming region when a reverse bias lower than the composite junction breakdown voltage of the source region, the drain region and the channel with respect to the channel forming region and/or to the well is applied.

By doing this, the electric field in the vertical direction between the channel and the channel forming region is reduced and a low breakdown voltage of the nearly step junction breakdown voltage is avoided.

The breakdown voltages of the source region and the drain region with respect to the channel forming region containing this effect will be referred to as the "composite junction breakdown voltage" in the present invention.

According to a second aspect of the present invention, there is provided a nonvolatile semiconductor memory device providing a plurality of memory cells comprising a channel forming region made of semiconductor and forming a channel in its surface; a source region and a drain region provided apart from each other in contact with the channel forming region; a gate insulating film formed on the channel forming region; a charge storing means embedded in the gate insulating film; and a control gate arranged above the charge storing means via the gate insulation layer, at least the control gates of part of the memory cells being connected to the same word line, comprising a means for applying to the drain region and the source region at the time of a write operation a voltage which is higher than that at which depletion layers extending from the junction portion between the drain region and the channel forming region of a non-written memory cell connected to the word line whose control gate is selected and from the junction portion of the source region and the channel forming region are superimposed in the channel forming region and which is lower than the composite junction breakdown voltage of the source region, the drain region and the channel with respect to the channel forming region and/or the well.

Note that the channel forming region can be the surface region of the semiconductor substrate per se when the substrate is a semiconductor, can be formed in the surface region of a well formed in the surface of the semiconductor substrate, and can be the silicon layer of a SOI (silicon-on-insulator) substrate.

Further, in the present invention, a mean impurity concentration of the channel forming region is desirably $2\varepsilon_{se}(V_{READ}+V_{bi})/qL_{eff}^2$ or more in order to avoid the punch through at the time of a read operation, where $\varepsilon_{se}$ is the dielectric constant of the channel forming region $V_{READ}$ is the drain-source voltage at the time of a read operation, $V_{bi}$ is the built-in voltage of the junction between the drain and channel forming regions, q is the electric charge of an electron, and $L_{eff}$ is the effective channel length.

Further, in the present invention, it is desirable that the mean impurity concentration of the channel forming region be $8\varepsilon_{se}(V_M+V_{bi})/qL_{eff}^2$ or less, where the write inhibit voltage is $V_M$, in order that the depletion layers be superimposed in the channel forming region.

Further, the present invention is preferably applied to an impurity concentration of a channel forming region with which an individual breakdown voltage between the channel and the channel forming region becomes smaller than the write inhibit voltage of 10V, that is, a concentration of the channel forming region of $1.5 \times 10^{17}$ cm$^{-3}$ or more. Further, the impurity concentration of the drain region and the source region is desirably lower than $2 \times 10^{20}$ cm$^{-3}$ for making the individual breakdown voltage of the drain region, and source region with respect to the well or channel forming region 10V or more.

Further, in the present invention, desirably the channel length is set to 0.5 μm or less.

According to a third aspect of the present invention, there is provided a method of application of a write voltage of a nonvolatile semiconductor memory device providing a plurality of memory cells comprising a channel forming region made of semiconductor and forming a channel in its surface; a source region and a drain region provided apart from each other in contact with the channel forming region; a gate insulating film formed on the channel forming region; a charge storing means embedded in the gate insulating film; and a control gate arranged above the charge storing means via the gate insulation layer, at least the control gates of part of the memory cells being connected to the same word line, wherein a voltage which is higher than that at which depletion layers extending from the junction portion between the drain region and the channel forming region of a non-written memory cell connected to a word line with a control gate which is selected and from the junction portion between the source region and the channel forming region are superimposed in the channel forming region and which is lower than the composite junction breakdown voltage of the source region, the drain region and the channel with respect to the channel forming region and/or the well is applied to the drain region and the source region at the time of a write operation.

According to the present invention, when a reverse bias is applied to the source region and drain region with respect to the channel forming region, depletion layers in the channel forming region extending from junction portions between the drain region and the channel forming region and between the source region and the channel forming region are formed so as to be superimposed in the channel forming region.

Due to this, the vertical electric field between the channel and the channel forming region is reduced, therefore the composite junction breakdown voltage of the drain region and source region and the channel with respect to the channel forming region and/or the well is improved.

Accordingly, when for example the absolute value of the inhibit voltage of the memory cell is larger than the absolute value of the individual breakdown voltage between the channel and the channel forming region given by an impurity concentration Nb of the channel forming region, the depletion layers extending from the drain region and the source region extend in a direction parallel to the surface of the channel forming region and are superimposed on each other, whereby the inhibit voltage of not less than a breakdown voltage given by the impurity concentration Nb of the channel forming region can be applied to the drain region, source region, and the channel.

Further, the depletion layers extending from the drain region and the source region reduce the electric field in the channel forming region at the portion where the depletion layers are superimposed, because the components of the electric field from the source and the drain regions in a direction parallel to the surface are opposite in the direction and cancel each other. Therefore the impurity concentration Nb of the channel forming region can be made more than Ncrit within a range where the composite junction breakdown voltage of the drain region and source region with reference to the channel forming region is not lowered to less than the inhibit voltage.

## BRIEF DESCRIPTION OF THE DRAWINGS

These and other objects and features of the present invention will become clearer from the following description of the preferred embodiments given with reference to the accompanying drawings, in which:

Fig. 1 is a sectional view of an embodiment of a nonvolatile semiconductor memory device according to the present invention;
Fig. 2 is a circuit diagram of an example of the configuration of a NAND type flash memory array constituted by using a nonvolatile semiconductor memory device having the structure shown in Fig. 1 as a memory cell;
Fig. 3 is a graph showing a composite junction breakdown voltage of drain-source regions and the channel with reference to the channel forming region by using the channel length as a parameter;
Fig. 4 is a graph showing another example of a composite junction breakdown voltage of the drain-source regions and the channel with reference to the channel forming region by using the channel length as a parameter;
Fig. 5 is a sectional view of the sectional structure of a nonvolatile semiconductor memory device having a floating gate as a charge storing layer; and
Fig. 6 is a view of the relationship of the composite junction breakdown voltage of the drain-source regions and the channel with reference to the channel forming region, as a function of a floating gate voltage.

## DESCRIPTION OF THE PREFERRED EMBODIMENTS

Below, preferred embodiments will be described with reference to the accompanying drawings.

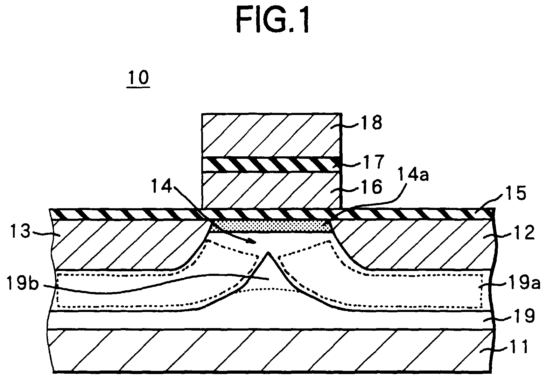

Figure 1 is a sectional view of an embodiment of a nonvolatile semiconductor memory device having a floating gate as the charge storing means according to the present invention.

As shown in Fig. 1, in this nonvolatile semiconductor memory device 10, a drain region 12 and a source region 13 are formed with a predetermined distance apart in the surface region of a silicon substrate 11.

A floating gate 16 serving as the charge storing means (charge storing layer) electrically insulated via an insulating film 15 made of for example $SiO_2$ is formed on a channel forming region 14 comprised of a semiconductor region sandwiched between the drain region 12 and the source region 13 and in the surface of which a channel is formed so as to be sandwiched between the drain region 12 and the source region 13.

Further, a control gate 18 for controlling the potential of the floating gate 16 is formed via an inter-layer insulating film 17.

Note that the floating gate 16 and the control gate 18 are formed by for example polycrystalline silicon, and the inter-layer insulating film 17 is formed by an ONO film comprising a laminate of an oxide film, nitride film, and oxide film.

Further, the present embodiment is structured with the gate insulating film constituted by the insulating film 15 and the inter-layer insulating film 17 and with the floating gate serving as the charge storing means embedded in the gate insulating film.

Here, the gate insulating film is defined as an assembly of the insulating film 15 and the inter-layer insulating film 17.

The nonvolatile semiconductor memory device 10 according to the present embodiment is formed by forming depletion layers 19a extending from junction portions between the drain region 12 and the channel forming region 14 and between the source region 13 and the channel forming region 14 so as to be superimposed in the channel forming region when a reverse bias lower than the composite junction breakdown voltage of the source region and drain region with reference to the channel forming region is applied to the source region 13 and drain region 12 with respect to the channel forming region 14. Further, when a high voltage is applied to the control gate, a channel is induced in the surface of the channel forming region. At this time, the depletion layer 19b appears between the channel forming region and the channel.

Further, the channel length, the impurity concentration of the channel forming region 14, and the impurity concentration of the drain region 12 and the source region 13 are set as follows for the reason as will be described later.

Namely, the specific channel length is set to 0.5 $\mu$m or shorter.

Further, the impurity concentration of the channel forming region 14 is set higher than $1.5 \times 10^{17}$ cm$^{-3}$, and the impurity concentration of the drain region 12 and the source region 13 is set lower than $2 \times 10^{20}$ cm$^{-3}$.

Note that, when the effective channel length is $L_{eff}$, in order to suppress punch through, the mean impurity concentration Nch of the channel forming region 14 is desirably $2\varepsilon_{se}(V_{READ}+V_{bi})/qL_{eff}^2$ or more where the dielectric constant of the channel forming region is $\varepsilon_{se}$, the drain-source voltage at the time of a read operation is $V_{READ}$, the built-in voltage of the junction between the drain and channel forming regions (built-in voltage) is $V_{bi}$, and electric charge of an electron is q.

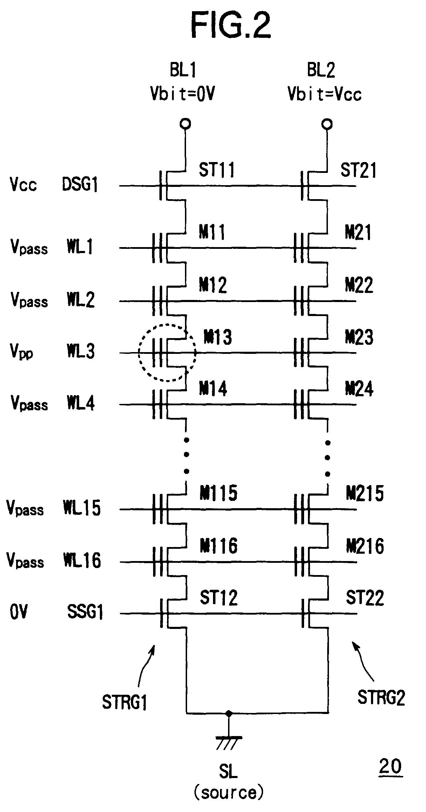

Figure 2 is a circuit diagram of an example of the configuration of a NAND type flash memory array constituted by using the nonvolatile semiconductor memory device 10 having the structure shown in Fig. 1 as a memory cell (memory transistor).

As shown in Fig. 2, in a memory array 20, memory strings STRG1, STRG2, ... are arranged in the form of a matrix.

The memory string STRG1 is constituted by 16 memory transistors M11 to M116 connected in series and two selection transistors ST11 and ST12 connected in series at the two ends thereof.

Similarly, the memory string STRG2 is constituted by 16 memory transistors M21 to M216 connected in series and two selection transistors ST21 and ST22 connected in series at the two ends thereof.

The selection transistor ST11 connected to the drain of the memory transistor M11 of the memory string STRG1 is connected to a bit line BL1, and the selection transistor ST21 connected to the drain of the memory transistor M21 of the memory transistor STRG2 is connected to a bit line BL2.

Further, the selection transistors ST12 and ST22 to which the memory transistors M116 and M216 of the memory strings STRG1 and STRG2 are connected are connected to a common source line SL.

Further, gate electrodes of memory transistors of the memory strings STRG1 and STRG2 arranged in the same row are connected to common word lines WL1 to WL16, gate electrodes of the selection transistors ST11 and ST21 are connected to a common selection gate line DSG1, and gate electrodes of the selection transistors ST12 and ST22 are connected to a common selection gate line SSG1.

In such a configuration, at the time of a write operation, a voltage which is higher than a voltage at which depletion layers extending from junction portions between the drain region 12 and the channel forming region 14 and between the source region 13 and the channel forming region 14 of a non-written memory cell connected to a word line with a control gate which is selected by a not illustrated decoder are superimposed in the channel forming region and which is lower than the composite junction breakdown voltage of the source region 12 and drain region 13 and the channel with respect to the channel forming region is applied to the drain region 12 and the source region 13.

In such a configuration, the write operation of the data into the memory transistor M13 of the memory string STRG1 is carried out as follows.

At the time of the write operation, a write voltage Vpp (for example, 20V) is applied to the word line WL3 selected by the not illustrated decoder and a pass voltage (intermediate voltage) Vpass (for example, 10V) is applied to the non-selected word lines WL1 to WL2 and WL4 to WL16. A power supply voltage $V_{CC}$ (for example, 3.3V) is supplied to a selection gate line DSG1, and a ground voltage GND (0V) is supplied to a selection gate line SSG1.

Further, a ground voltage GND (0V) is applied to the bit line BL1 to which the memory string STRG1 having a memory transistor M13 which should perform the write operation is connected, while the power supply voltage $V_{CC}$ is applied to the bit line BL2 to which the memory string STRG2 having the memory transistor M23 to which the writing should be inhibited is connected.

Due to this, the selection transistor ST21 of the memory string STRG2 becomes cut off in state, and the channel of the memory string STRG2 to which the memory transistor M23 which should inhibit the write operation is connected becomes floating in state.

As a result, the potentials of these channels are mainly boosted by capacitor coupling with the pass voltage Vpass applied to the non-selected word line and rise to the write inhibit voltage VM, thus the data write operation to the memory transistor M23 of the memory string STRG2 is inhibited.

On the other hand, the potential of the channel of the memory string STRG1 to which the memory transistor which should perform the write operation is connected is set at the ground voltage GND (0V), the write operation of the data into the memory transistor M13 is carried out by the potential difference from the write voltage applied to the selected word line WL3, for example, 20V, and a threshold voltage shifts in a positive direction and becomes for example about to 2V from -3V of the erased state.

Next, the behavior of the memory transistor to which the write operation should be inhibited during the time of the above write operation will be considered.

In the memory transistor, depletion layers 19a are formed in the channel forming region and well by the inhibit voltage $V_M$ applied to the drain region 12 and source region 13 by using for example a self boost effect.

Specifically, as shown in Fig. 1, depletion layers of the drain 12 and the source 13 are formed so as to be superimposed in the channel forming region while extending in a direction parallel to the surface of the channel forming region from the two sides of the channel forming region 14.

As explained above, the shorter the channel length of the memory cell, the larger the impurity concentration of the channel forming region 14 in the well 19 must become in order to suppress the punch through, therefore the individual breakdown voltage between the channel and the channel forming region 14 becomes smaller.

On the other hand, it is possible to raise the breakdown voltages of the drain and source regions and the channel forming region or well by lowering the impurity concentration of the drain region and the source region at least at the portions facing each other. Accordingly, when the impurity concentration of the channel forming region is made high along with the shortening of the channel length of the memory cell, the breakdown voltage between the channel 14a and the channel forming region 14 can be lower than the junction breakdown voltage of the drain region and source region with reference to the channel forming region 14 or well 19.

In the nonvolatile semiconductor memory device (memory transistor) according to the present embodiment shown in Fig. 1, depletion layers 19a from the drain region and the source region superimpose in the channel forming region 14, while extending in a direction parallel to the surface of the channel forming region 14, therefore the vertical electric field between the channel 14a and the channel forming region 14 is reduced and thus the composite junction breakdown voltage is improved.

When the channel forming region is made shorter, finally the composite junction breakdown voltage is determined by the junction breakdown voltages of the drain region and source region with reference to the well.

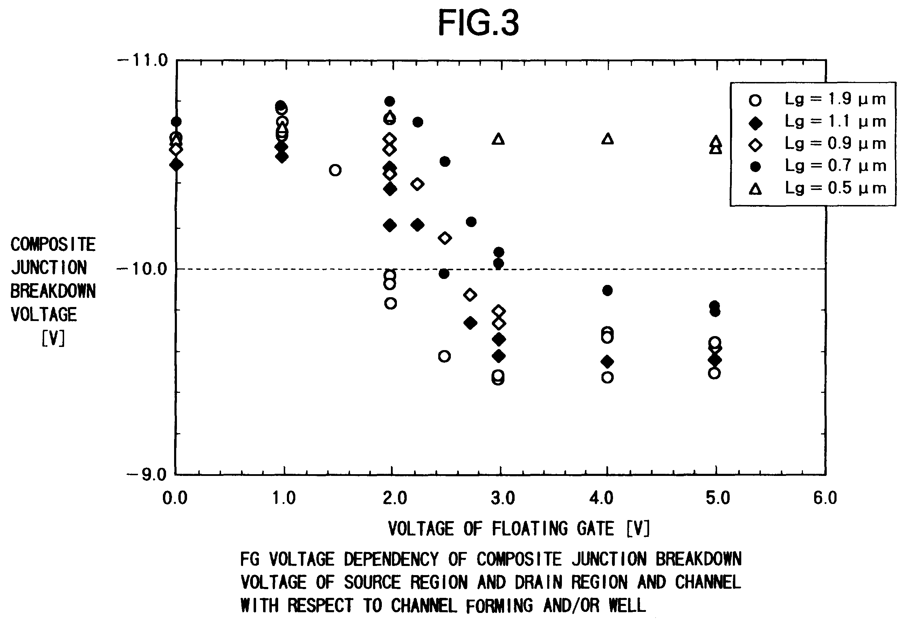

Figure 3 is a graph showing of the composite junction breakdown voltage of the drain and source region and the channel with reference to the channel forming region and/or well by using the channel length as a parameter.

In Fig. 3, the abscissa represents the voltage applied to the floating gate, while the ordinate represents the composite junction breakdown voltage of the source region, drain region and channel with reference to the channel forming region.

Note that, as specimens giving the characteristics of Fig. 3, ones having channel lengths Lg of 1.9 μm, 1.1 μm, 0.9 μm, 0.7 μm, and 0.5 μm, an impurity concentration of the channel forming region of about 1.5 x $10^{17}$ cm$^{-3}$, and an impurity concentration of the drain region and source region of 2 x $10^{19}$ cm$^{-3}$ were used.

As shown in Fig. 3, when the potential of the floating gate 16 with reference to the source region becomes larger than the threshold value (about 2V in Fig. 3) of the cell transistor and the channel 14a is formed, a reduction of the breakdown voltage is seen when the channel length is longer than 0.7 μm.

This tendency becomes more conspicuous as the channel length becomes longer.

This indicates that the composite junction breakdown voltage had been determined by the junction breakdown voltages of the drain region 12 and source region 13 with reference to the channel forming region 14 and/or the well 19 and/or the floating gate 16 until the channel is formed, but when the channel 14a is formed, it is determined by the breakdown voltage between the channel and the channel forming region 14. It should be noted that the individual junction breakdown voltages are also modified due to the electric field between the floating gate and the source, drain regions.

However, when the channel length becomes 0.5 μm, the reduction of the breakdown voltage due to the formation of the channel is small. Further, it is apparent that the reduction of the breakdown voltage due to the formation of the channel is small even if the channel length becomes shorter than 0.5 μm for the above reason.

This shows that the vertical electric field between the channel and the channel forming region 14 is reduced since depletion layers 19a from the drain region 12 and the source region 13 extend in directions parallel to the surface of the channel forming region 14, are superimposed, and the electric field film from the channel into the channel forming region is reduced.

In this way, when the impurity concentration of the channel forming region 14 is large and the inherent breakdown voltage is determined by the breakdown voltage between the channel and the channel forming region, an inhibit voltage more than this breakdown voltage cannot be applied to the drain region, source region, and channel, but by shortening the channel length as in Fig. 1 and making it so that the depletion layers 19a from the drain region 12 and the source region 13 extend in a parallel direction to the surface of the channel forming region 14 and are superimposed when a reverse bias is applied to the drain region and the source region with respect to the channel forming region, an inhibit voltage of more than the individual breakdown voltage between the channel and the channel forming region 14 can be applied to the drain region 12, the source region 13, and the channel.

Note that the inhibit voltage which can be applied at this time is the junction breakdown voltages of the drain region 12 and source region 13 with reference to the well 19 and/or floating gate 16 at the most.

In other words, when the individual breakdown voltage between the channel and the channel forming region 14 required for the inhibit voltage $V_M$ of the memory cell corresponds to the impurity concentration of the channel forming region, the larger impurity concentration Nb of the channel forming region of the memory cell can be adopted to prevent the punch-through than the critical value Ncrit at which the individual breakdown voltage between the channel and the channel forming region is the inhibit voltage $V_M$ when the effect of the present invention is not adopted.

However, as in the nonvolatile semiconductor memory device 10 according to the present embodiment shown in Fig. 1, the depletion layers 19a from the drain region 12 and the source region 13 extend in a parallel direction to the surface of the channel forming region 14 and are superimposed when the reverse bias is applied to the drain region and source region with reference to the channel forming region by shortening the channel length, whereby an inhibit voltage of more than the individual breakdown voltage given by the impurity concentration Nb of the channel forming region can be applied to the drain region 12 and source region 13 and the channel with reference to the channel forming region.

Further, when the channel length is shortened, it is also possible to make the impurity concentration Nb of the channel forming region 14 more than Ncrit within the range where the junction breakdown voltages of the drain region 12 and source region 13 with reference to the channel forming region 14 are not lowered to less than the inhibit voltage.

Note that the mean value of this Nb in the direction along the surface of the channel forming region must be less than $8\varepsilon_{se} (V_M+V_{bi})/qL_{eff}^2$ for superimposition of the depletion layers 19a from the drain region and the source region in the channel forming region.

Due to this, a transistor having a further shorter channel length can be formed.

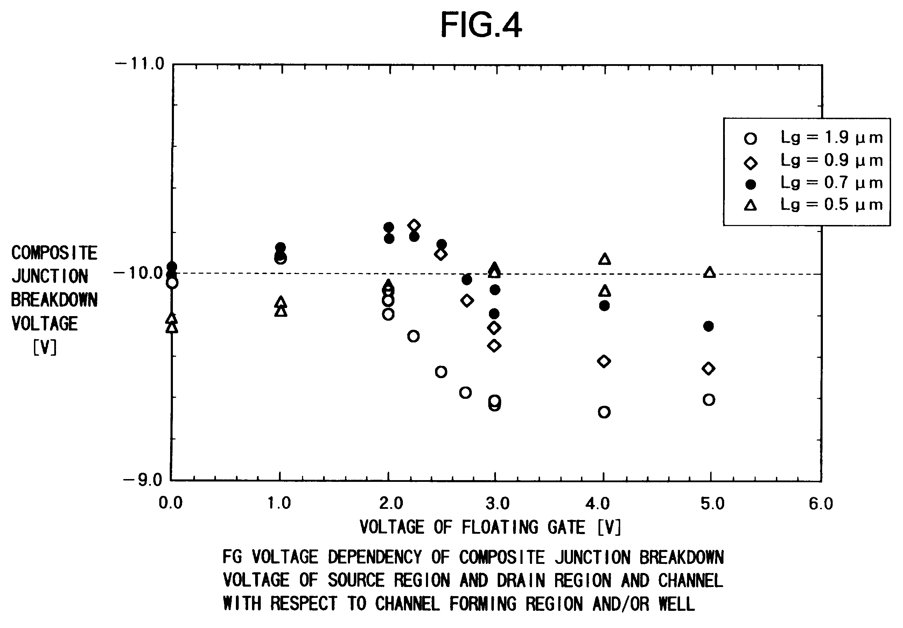

Further, as another example, the results when the impurity concentration of the channel forming region of the memory cell is $1.5 \times 10^{17}$ cm$^{-3}$ and the impurity concentration of the drain and the source is $2 \times 10^{20}$ cm$^{-3}$ will be shown in Fig. 4.

In Fig. 4, the abscissa represents the voltage applied to the floating gate, and the ordinate represents the composite junction breakdown voltage of the source region and drain region and the channel with reference to the channel forming region, and/or the well and/or the floating gate.

It will be understood from Fig. 4 that the junction breakdown voltages of the drain region 12 and source region 13 with reference to the channel forming region 14, and/or well 19 and/or the floating gate become higher than the breakdown voltage between the channel 14a and the channel forming region 14 when the impurity concentration of the channel forming region 14 is $1.5 \times 10^{17}$ cm$^{-3}$ and the impurity concentration of the drain region 12 and the source region 13 is equal or lower than $2 \times 10^{20}$ cm$^{-3}$. The method according to the present invention has this effect.

As is indicated by the experimental results, the impurity concentration of $1.5 \times 10^{17}$ cm$^{-3}$ for the channel forming region is effective for the gate length less than 0.6 $\mu$m (in between the experimental points of Lg=0.5 and 0.7$\mu$m). For shorter channel devices, higher impurity concentration is applicable to the channel forming region.

As explained above, according to the present embodiment, when individual single breakdown voltage between the channel and the channel forming region required for the inhibit voltage of the memory cell corresponds to the impurity concentration Nb of the channel forming region 14, as shown in Fig. 1, by forming the depletion layers 19a from the drain region 12 and the source region 13 so as to extend in a parallel direction to the surface of the channel forming region 14 and be superimposed when a reverse bias is applied between the drain region and the channel forming region and between the source region and the channel forming region by shortening the channel length, an inhibit voltage of more than the individual breakdown voltage given by the impurity concentration Nb of the channel forming region can be applied to the drain region 12 and the source region 13 and the channel with reference to the channel forming region.

In this way, the inhibit voltage can be made large, therefore, there is a special effect that a large operational margin of the write disturb characteristic of a non-written cell can be obtained.

Further, where the device is configured so that the depletion layers 19a from the drain region 12 and the source region 13 extend in a parallel direction to the surface of the channel forming region 14 and are superimposed when a reverse bias is applied between the drain region and the channel forming region and between the source region and the channel forming region, it is also possible to make the impurity concentration Nb of the channel forming region 14 more than Ncrit within the range where the composite junction breakdown voltage of the drain region 12 and source region 13 with reference to the channel forming region 14 is not lowered to less than the inhibit voltage. By this, there is an advantage that a transistor having a further shorter channel length can be formed.

Note that, in the present embodiment, as an example, a NAND type of cell array configuration was explained, but the present invention is effective even with another type of arrangement of cell array which operates to apply voltage to the drain region, source region, and control gate of non-written cells.

Further, as the channel forming region, the well formed in a main surface of the semiconductor substrate was explained as an example, but for example an epitaxial layer formed on the main surface of the semiconductor substrate can be used too as the channel forming region.

Further, similar effects can be obtained even if an SOI substrate in which a semiconductor layer is formed on a substrate in a state insulated from the supporting substrate is used as the substrate.

Further, in the present embodiment, an explanation was made taking as an example a nonvolatile semiconductor memory device having a floating gate type charge storing layer, but needless to say the present invention can be applied to for example a MONOS type nonvolatile semiconductor memory device having a charge storing means made discrete in for example the gate insulating film.

As explained above, according to the present invention, there is the advantage that a write inhibit voltage of more than the individual breakdown voltage given as the impurity concentration of the channel forming region can be applied to the drain region and source region and the channel with reference to the channel forming region, consequently the operational margin of the write disturb characteristic of the non-written cells can be made large.

Further, when the depletion layers from the drain region and the source region are formed so as to extend in a parallel direction to the surface of the channel forming region and be superimposed when a reverse bias is applied to the drain region and source region with reference to the channel forming region, it is also possible to make the impurity concentration of the channel forming region high within the range where the composite junction breakdown voltage between the drain region and the channel forming region and between the source region and the channel forming region is not lowered to less than the inhibit voltage. By this, the channel length can be further shortened.

While the invention has been described with reference to specific embodiment chosen for purpose of illustration, it should be apparent that numerous modifications could be made thereto by those skilled in the art without departing from the basic concept and scope of the invention.

## Claims

1. A nonvolatile semiconductor memory device (10) comprising a channel forming region (14) made of a semiconductor and forming a channel (14a) in its surface; a source region (13) and a drain region (12) provided apart from each other in contact with the channel forming region (14); a gate insulating film (15) formed on the channel forming region (14); a charge storing means (16) embedded in the gate insulating film (15, 17); and a control gate (18) arranged above the charge storing means (16) via the gate insulating film (17),

   wherein depletion layers (19a) extending from a junction portion between the source region (13) and the channel forming region (14) and from a junction portion between the drain region (12) and the channel forming region (14) are formed so as to be superimposed on each other in the channel forming region (14) when a reverse bias lower than the composite junction breakdown voltage of the source region (13) and the drain region (12) with reference to the channel forming region (14) is applied.

2. A nonvolatile semiconductor memory device as set forth in claim 1, wherein the mean impurity concentration of the channel forming region (14) is more than $2\varepsilon_{se}(V_{READ}+V_{bi})/qL_{eff}^{2}$, where $\varepsilon_{se}$ is the dielectric constant of the channel forming region (14), $V_{READ}$ is the drain-source voltage at the time of a read operation $V_{bi}$ is the built-in voltage of the junction between the drain and channel forming regions (12, 14), q is the electric charge of an electron, and $L_{eff}$ is the effective channel length.

3. A nonvolatile semiconductor memory device as set forth in claim 1, wherein the mean impurity concentration of the channel forming region (14) is $8\varepsilon_{se}(V_{M}+V_{bi})/qL_{eff}^{2}$ or less, where $V_{M}$ is the write inhibit voltage.

4. A nonvolatile semiconductor memory device as set forth in claim 1, wherein the impurity concentration of the channel forming region (14) is more than $1.5 \times 10^{17}$ cm$^{-3}$ and the impurity concentration of the drain region (12) and the source region (13) at the part facing each other is lower than $2 \times 10^{20}$ cm$^{-3}$.

5. A nonvolatile semiconductor memory device as set forth in claim 4, wherein the channel length is set to 0.5 $\mu$m or less.

6. A nonvolatile semiconductor memory device as set forth in claim 1, wherein the channel forming region (14) is formed by an epitaxial layer.

7. A nonvolatile semiconductor memory device as set forth in claim 1, wherein the channel forming region (14) is comprised of a semiconductor layer provided on a substrate insulated from the same (SOI).

8. A nonvolatile semiconductor memory device as set forth in claim 1, wherein the charge storing means is comprised by a floating gate (16) comprising an insulating film (15) above the channel forming region (14).

9. A nonvolatile semiconductor memory device as set forth in claim 1, wherein the charge storing means (14) is distributed discretely in an insulating film (15) formed on the surface of the channel forming region (14).

10. A nonvolatile semiconductor memory device providing a plurality of memory cells comprising a channel forming region (14) made of semiconductor and forming a channel (14a) in its surface; a source region (13) and a drain region (12) provided apart from each other in contact with the channel forming region (14); a gate insulating film (15) formed on the channel forming region (14); a charge storing means embedded in the gate insulating film (15, 17); and a control gate (18) arranged above the charge storing means (16) via the gate insulation layer (17), at least the control gates of part of the memory cells being connected to the same word line, comprising:

a means for applying to the drain region (12) and the source region (13) at the time of a write operation a voltage which is higher than that at which depletion layers (19a) extending from the junction portion between the drain region (12) and the channel forming region (14) of a non-written memory cell connected to the word line whose control gate is selected and from the junction portion between the source region (13) and the channel forming region (14) are superimposed in the channel forming region (14) and which is lower than the composite junction breakdown voltage of the source region (13) and the drain region (12) with respect to the channel forming region (14).

11. A nonvolatile semiconductor memory device as set forth in claim 10, wherein the mean impurity concentration of the channel forming region (14) is more than $2\varepsilon_{se}(V_{READ}+V_{bi})/qL_{eff}^2$, where $\varepsilon_{se}$ is the dielectric constant of the channel forming region (14), $V_{READ}$ is the drain-source voltage at the time of a read operation, $V_{bi}$ is the built-in voltage of the junction between the drain and channel forming regions (12, 14), q is the electric charge of an electron, and $L_{eff}$ is the effective channel length.

12. A nonvolatile semiconductor memory device as set forth in claim 10, wherein the mean impurity concentration of the channel forming region (14) is $8\varepsilon_{se}(V_M+V_{bi})/qL_{eff}^2$ or less, where $V_M$ is the write inhibit voltage.

13. A nonvolatile semiconductor memory device as set forth in claim 10, wherein the impurity concentration of the channel forming region (14) is more than $1.5 \times 10^{17}$ cm$^{-3}$ and the impurity concentration of the drain region (12) and the source region (13) is lower than $2 \times 10^{20}$ cm$^{-3}$.

14. A nonvolatile semiconductor memory device as set forth in claim 13, wherein the channel length is set to 0.5 $\mu$m or less.

15. A nonvolatile semiconductor memory device as set forth in claim 10, wherein the channel forming region (14) is formed by an epitaxial layer.

16. A nonvolatile semiconductor memory device as set forth in claim 10, wherein the channel forming region (14) is comprised of a semiconductor layer provided on a substrate insulated from the same (SOI).

17. A nonvolatile semiconductor memory device as set forth in claim 10, wherein the charge storing means is comprised by a floating gate (16) comprising an insulating film (15) above the channel forming region (14).

18. A nonvolatile semiconductor memory device as set forth in claim 10, wherein the charge storing means (16) is distributed discretely in an insulating film (15) formed on the surface of the channel forming region (14).

19. A method of application of a write inhibit voltage of a nonvolatile semiconductor memory device providing a plurality of memory cells comprising a channel forming region (14) made of semiconductor and forming a channel (14a) in its surface; a source region (13) and a drain region (12) provided apart from each other in contact with the channel forming region (14); a gate insulating film (15) formed on the channel forming region (14); a charge storing means (16) embedded in the gate insulating film (15, 17); and a control gate (18) arranged over the charge storing means (16) via the gate insulating layer (17), at least the control gates of part of the memory cells being connected to the same word line,

wherein a voltage which is higher than that at which depletion layers (19a) extending from the junction portion between the drain region (12) and the channel forming region (14) of a non-written memory cell connected to a word line with a control gate which is selected and from the junction portion between the source region (13) and the channel forming region (14) are superimposed in the channel forming region (14) and which is lower than the composite junction breakdown voltage of the source region (13) and the drain region (12) with respect to the channel forming region (14) is applied to the drain region (12) and the source region (13) at the time of a write operation.

20. A method of application of a write inhibit voltage of a nonvolatile semiconductor memory device as set forth in claim 19, wherein the impurity concentration of a channel forming region (14) is more than $1.5 \times 10^{17}$ cm$^{-3}$ and the impurity concentration of the drain region (12) and the source region (13) at the portion facing each other is lower than $2 \times 10^{20}$ cm$^{-3}$.

# FIG.1

# FIG.2

SL
(source)

20

# FIG.3

FG VOLTAGE DEPENDENCY OF COMPOSITE JUNCTION BREAKDOWN
VOLTAGE OF SOURCE REGION AND DRAIN REGION AND CHANNEL
WITH RESPECT TO CHANNEL FORMING AND/OR WELL

EP 0 923 139 A2

# FIG.4

FG VOLTAGE DEPENDENCY OF COMPOSITE JUNCTION BREAKDOWN
VOLTAGE OF SOURCE REGION AND DRAIN REGION AND CHANNEL
WITH RESPECT TO CHANNEL FORMING REGION AND/OR WELL

EP 0 923 139 A2

# FIG.5

(SIDEWALL
INSULATOR)

(SIDEWALL
INSULATOR)

# FIG.6

COMPOSITE JUNCTION BREAKDOWN VOLTAGE [V] (y-axis)

VOLTAGE OF FLOATING GATE [V] (x-axis)

O  Lg = 1.9 μm

VOLTAGE DEPENDENCY OF COMPOSITE JUNCTION BREAKDOWN
VOLTAGE OF SOURCE REGION AND DRAIN REGION AND CHANNEL
WITH REFERENCE TO CHANNEL FORMING REGION AND/OR WELL

EP 0 923 139 A2